Europäisches Patentamt

European Patent Office

Office européen des brevets

(11) Publication number: **0 458 256 A1**

## (12) EUROPEAN PATENT APPLICATION

(21) Application number: **91108162.8**

(22) Date of filing: **21.05.91**

(51) Int. Cl.5: **H04B 10/16**

(30) Priority: **25.05.90 IT 2043490**

(43) Date of publication of application:
**27.11.91 Bulletin 91/48**

(84) Designated Contracting States:
**AT BE CH DE DK ES FR GB LI LU NL SE**

(71) Applicant: **PIRELLI CAVI S.p.A.**
**Piazzale Cadorna, 5**
**I-20123 Milan(IT)**

(72) Inventor: **Grasso, Giorgio**
**Via Canesi, 8**
**Monza (MI)(IT)**
Inventor: **Righetti, Aldo**
**Via Tolstoi, 49**
**Milan(IT)**

(74) Representative: **Giannesi, Pier Giovanni et al**
**Pirelli S.p.A. Direzione Brevetti Piazzale**
**Cadorna, 5**
**I-20123 Milano(IT)**

(54) **Unit for amplifying signals of light in optical fiber transmission lines.**

(57) The present invention relates to a optical fiber telecommunication line comprising active-fiber (10) optical amplifiers (5, 6) in which the reflectivity towards the amplifiers' active fiber is limited below a critical value lower by at least 10 dB than the reflectivity due to the Rayleigh scattering within the line fibres; this reflectivity value is obtained by arranging optical isolators (11a, 11b) having a limited inner reflectivity upstream and downstream of the amplifier (6) and by disposing reflection limiting means on all fibres (12) converging towards the amplifier's active fiber (10).

Fig. 2

EP 0 458 256 A1

The present invention relates to an optical fiber telecommunication line, provided with active-fiber optical amplifiers in which the reflections towards the amplifiers are contained below a predetermined value.

It is known that optical fibres having a doped core in which the doping is carried out with the use of particular substances such as rare earth ions, have stimulated emission features and are suitable for use as fiber optical amplifiers in optical fiber telecommunication lines for civil telephony.

Such kind of amplifiers are referred to in the European patent application N° 90112920.5 of the same Applicant.

By optical fiber amplifiers, also referred to as optical active fiber amplifiers, it is meant amplifiers in which the optical transmission signal is amplified as such, while keeping its optical form, without being required a reception or conversion of the same to another form, such as for example the electronic one, an amplification in said form and a new conversion to the optical form, and in which the amplifying element consists of a portion of optical fiber of the above described type having a predetermined length, connected in series between two lengths of optical line fiber and provided with respective feeding means to feed the optical pumping signal.

Amplifiers of this kind have particular advantages for use in telecommunication lines, as they offer high gains when they are utilised as line amplifiers, which gains can be brought to the desired value by suitably selecting the active fiber length and/or contents in dopant, or, should they be used as power amplifiers, they offer a high amplification efficiency.

Particularly dangerous to amplifiers are the signal reflections which occur at the ends of the fiber itself.

From Japanese patents 52-155901 and 63-219186 and from "ELECTRONICS LETTERS", vol. 24, no. 1, 7th January 1988, pages 36-38, it is known that in a laser or optical semiconductor amplifier there is the risk of instability and arising of oscillations due to the reflections at the amplifier ends.

In the above patents and article, in order to eliminate these reflections, it is generically taught to couple an optical isolator to the semiconductor laser, which prevent the light reflected by the coupling surfaces between the line fibres and these devices from reaching the lasers themselves.

In an active-fiber amplifier no interface surfaces are present between the line fibres and the amplifier because the line fibres are directly welded to the amplifier's active fiber; therefore the reflection phenomena are not generally expected.

It has however been discovered that in an active-fiber amplifier, in the absence of reflection limiting means towards the active fiber, it is impossible to reach high amplification gains due to the occurrence of noise of the interferometric type as a result of beatings between the direct signal and reflected signals in the line fibres themselves and at all events directed towards the active fiber; the presence of interferometric noise is of little importance in a semiconductor amplifier which has low gains and small construction sizes, whereas it becomes particularly important in an active-fiber amplifier capable of reaching very high gains and having an active fiber of important length generally in the range of some tens of meters, much greater than the coherence distance of the signal generating laser.

In an amplifier of the active core fiber type the problem arises therefor of protecting the active fiber against such noise source and keeping each form of reflection towards the active fiber itself below critical values so as not to jeopardise the transmission quality, while maintaining high values in the amplification gain.

The above cited European patent application N° 90112920.5 teaches to introduce optical isolators in fiber optical amplifiers, said isolators having a reflectivity limited below a critical value.

The present invention aims at providing an optical fiber telecommunication line comprising active-fiber optical amplifiers in which the amplifiers are protected against all drawbacks resulting from reflections, according to the teaching of the European patent application N° 90112920.5, pointing out further critical parameters permitting to choose the most suitable optical isolation characteristics for the expected amplifier gain.

In is an object of the present invention an optical fiber telecommunication line, in which an optical transmission signal is brought from one end of the line to the other end without regenerations, along which line at least an optical fiber amplifier is present comprising an active optical fiber length having a doped core in which the doping is carried out by fluorescent substances, characterised in that all fibres connected to the amplifier's active fiber or belonging to each amplifier have reflection limiting means the reflectivity of which, seen from the faced end of the active fiber, is lower by at least 10 dB than the reflectivity corresponding to the Rayleigh scattering in the fiber at the transmission wavelength.

Preferably the reflection limiting means cause reflectivities of the fibres converging towards the active fiber which are equal to or lower by 15 dB than the reflectivity corresponding to the Rayleigh scattering in the fiber at the transmission wavelength.

According to a particular embodiment, above all for the purpose of reaching high amplification gains, all fibres connected to the amplifier's active fiber or belonging to each amplifier are provided with reflection limiting means having a reflectivity, seen from the faced end of the active fiber, the absolute value of which is higher by at least 10 dB and preferably at least 15 dB than the expected amplifier gain.

The reflection limiting means comprises polarisation control optical isolators located upstream and downstream of the optical active fiber of the amplifier.

The optical isolators are of a type insensitive to the polarisation of the transmission signal.

The fibres connected to the amplifier's active fiber, devoid of optical isolators, have antireflection coatings and/or an oblique cut of the surface(s) passed through by the transmission signal giving rise to a reflectivity at the transmission signal wavelength lower by at least 10 dB and preferably at least 15 dB than the reflectivity corresponding to the Rayleigh scattering in the fiber at the transmission wavelength, or the absolute value of which is higher by at least 10 dB and preferably at least 15 dB than the expected amplifier gain.

It is also an object of the present invention an optical amplifier for optical fiber telecommunication lines of the active fiber type comprising an active optical fiber having a core doped with a fluorescent substance, connected at the ends thereof to the optical fibres of a telecommunication line, to which active optical fiber being also connected, through respective coupling means, at least an optical fiber connected to a source of an optical pumping signal, characterised in that all fibres connected to the active fiber exhibit reflection limiting means causing a reflectivity, seen from the faced end of the active fiber, lower by at least 10 dB and preferably at least 15 dB, than the reflectivity corresponding to the Rayleigh scattering in the fiber at the transmission wavelength, or the absolute value of which is higher by at least 10 dB and preferably at least 15 dB than the expected amplifier gain.

In the above amplifier the reflection limiting means comprises polarisation control optical isolators located upstream and downstream of the active optical fiber; the optical isolators are of the type insensitive to polarisation.

Each optical isolator has a reflectivity towards the active fiber at the wavelength of the transmission signal lower by 10 dB and preferably 15 dB than the reflectivity given by the Rayleigh scattering in the line fiber, or the absolute value of which is higher by at least 10 dB and preferably at least 15 dB than the expected amplifier gain.

The optical fiber connected to the optical pumping source is devoid of optical isolators and at the end thereof connected to said source is provided with reflection limiting means comprising antireflection coating layers and/or an oblique cut of the surface(s) passed through by the transmission signal, said reflection limiting means supplying a reflectivity which is lower by 10 dB and preferably by 15 dB than the reflectivity resulting from the Rayleigh scattering, or the absolute value of which is higher by at least 10 dB and preferably at least 15 dB than the expected amplifier gain, the attenuations due to the passage of the transmission signal and reflected signal through the coupling means being included.

The end of the optical fiber connected to the pumping signal source is cut at an angle ranging between 5° and 10° with respect to the plane normal to the fiber axis.

The fiber connected to the source of the optical pumping signal is connected to the active fiber through a dichroic coupler and the optical isolators are interposed between the active fiber and the optical line fiber, at one end thereof, and between the line fiber and the optical coupler immediately contiguous to the active fiber, at the other end of the active fiber itself; alternatively the fiber connected to the source of the optical pumping signal is connected to the active fiber through a dichroic coupler and an optical isolator is interposed between the active fiber and the dichroic coupler.

In case of power amplifiers operating with a power transmission signal higher than the saturation power of the amplifier and connected at a position contiguous to the the transmission signal emitting laser, equipped with the respective protection optical isolator, an optical isolator is present only at the downstream end of the active fiber in the running direction of the transmission signal.

More details will become apparent from the following description of the invention given hereinafter with reference to the accompanying drawings, in which:

Fig. 1    is a diagram of an optical fiber telecommunication line, provided with line and power amplifiers,

Fig. 2    is a structural diagram of an active-fiber optical line amplifier, according to a preferred embodiment of the invention;

Fig. 3    is a structural diagram of an active-fiber optical line amplifier according to an alternative embodiment thereof;

Fig. 4    is a structural diagram of an active-fiber optical power amplifier in accordance with the invention.

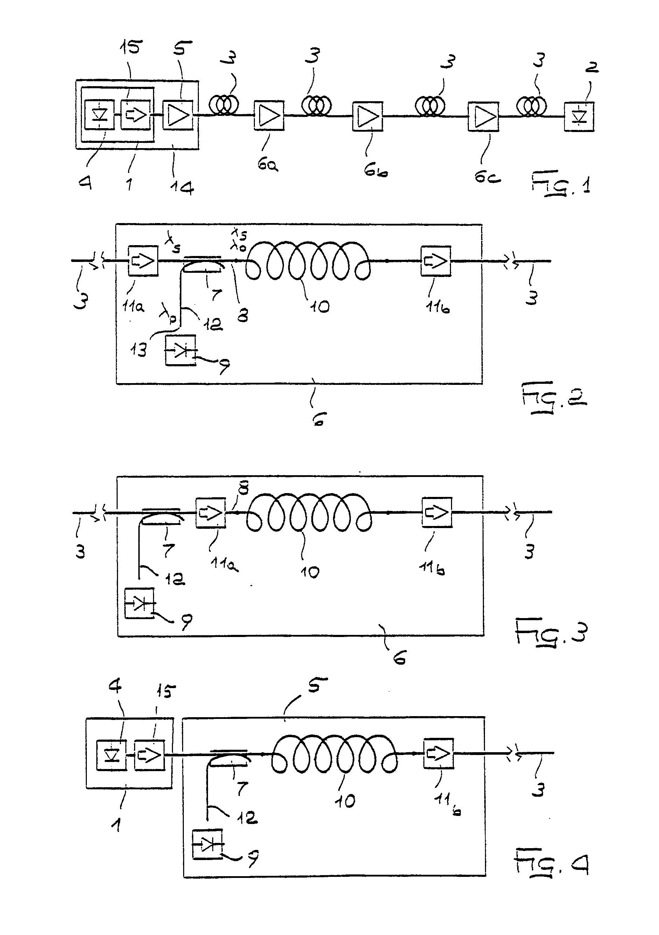

As shown in Fig. 1, an optical fiber telecommunication line generally comprises an emission station 1, and a reception station 2, located far away from each other, hundreds or thousands of kilometres far, for example; interposed between the two stations is an optical fiber 3, having suitable transmission characteristics, through which the signal is guided from one station to the other.

In order to cover the desired overall distance between stations 1 and 2 it is necessary first to send a signal of sufficient power and subsequently compensate for the signal attenuation along the fiber; therefore the emission station comprises, immediately after the laser 4 generating the optical signal to be transmitted, a power amplifier 5 adapted to input a signal in the line which has a higher power than the one achievable or that can be conveniently generated through the laser 4; in addition, after a certain fiber length, some hundreds of kilometres for example, a first line amplifier 6a is present, generally shown in the figure, adapted to bring the signal back to a sufficiently high level and followed by further fiber lengths and respective amplifiers 6b, 6c and so on, which are herein present until the whole assigned distance has been covered.

Amplifiers 5, 6 can conveniently consist of optical amplifiers; these amplifiers are particularly adapted to the stated applications because therein the signal maintains the optical form and therefore its reading and conversion to an electronic form as well as processing and amplification and a new conversion to the optical form for running through the line again are not required.

These operations in fact restrict the line capacity, in particular as regards transmission speed which is conditioned by the processing speed of the electronic apparatuses used.

On the contrary, in an optical-type amplifier the signal always remains under an optical form and therefore it is not subjected to transmission speed restrictions and the like.

In addition it is particularly convenient to use optical amplifiers of the active-core optical fiber type.

In fact these amplifiers allow particularly good performances to be achieved both as regards gain and efficiency.

The structure of an optical fiber amplifier is diagrammatically shown in Fig. 2; the line fiber 3 in which a transmission signal that must be amplified travels at the wavelength $l_s$ is connected to a dichroic coupler 7 in which the transmission signal is joined on a single outgoing fiber 8 with a pumping signal of wavelength $l_p$, generated by a pumping laser emitter 9; an active fiber 10, connected to the fiber 8 coming out of the coupler constitutes the signal amplifying element which is therefore introduced again into the line fiber 3 thus going on towards its destination.

In order to make the active fiber 10 forming the amplifying element of the assembly, a silicon-based optical fiber is used the core of which is doped with a fluorescent substance that, in the presence of luminous pumping light at the wavelength $l_p$ is capable of generating a stimulated emission coherent with the signal at the transmission wavelength $l_s$, so that the outgoing signal appears greatly amplified relative to the incoming signal.

It is known that in any amplifier the gain G is linked to the reflectivities $R_1$, $R_2$ measured at the ends thereof by the relation:

$$G(dB) < -1/2 [R_1(dB) + R_2(dB)], \qquad 1)$$

in which reflectivities $R_1$, $R_2$ are defined as:

$$R(dB) = 10 \ln (P_r/P_t)$$

where $P_t$ is the transmitted power, whereas $P_r$ is the reflected power.

Substantially the foregoing means that the achievement of high gains in the amplifier is limited by the reflection characteristics at the ends of the amplifier itself, or, in other words, that in order to achieve high amplification gains it is necessary to have high reflectivities $R_1$ and $R_2$.

In fact, if one part of the light signal present within the amplifier is reflected back to the end thereof, said part is amplified, partly reflected again at the opposite end and introduced again into the amplifier, the cycle being repeated several times; when said reflections and amplifications globally take a high value it is possible to reach an oscillation condition which makes the correct operation of the amplifier impossible which dictates that the maximum amplification gain must be limited in order to avoid the occurrence of this phenomenon.

In addition to this phenomenon, the reflection back within the amplifier of the transmission signal itself by the reflecting elements downstream of the amplifier (the line fiber itself for example), where said reflection is amplified again and further reflected by reflecting elements located upstream of the amplifier, gives rise to a beating phenomenon between the direct and reflected signals, referred to as interferometric noise.

This interferometric noise becomes particularly important in the case of active-fiber amplifiers, which have a length of the amplifying element, that is the fiber, higher than the length corresponding to the laser coherence time which has generated the signal; under these conditions in fact, the coherence between the direct and the reflected signals being lost, the reflected signal becomes offset relative to the direct signal and, if it has sufficient intensity, it becomes detrimental to the transmission quality.

The reflections that can take place in the amplifier can be due to the presence of interface surfaces at the ends thereof as a result of the well known refraction phenomena, but also in the absence of these surfaces, as in the case of fiber amplifiers, in which the amplifying element consists of an active fiber 10 directly welded to the coupler 7 and the line fibres, it is the scattering at the inside of the line fiber upstream and downstream of the amplifier (known as "Rayleigh scattering") that produces a reflection of the luminous power.

It has been noted in fact that the Rayleigh scattering which occurs in the whole fiber, produces a reflectivity the value of which is about -30 dB.

Further reflection forms can be produced when strong luminous powers are transmitted, due to the phenomenon known as "Brillouin scattering".

According to the present invention, the limitations to the maximum gain achievable in a line amplifier resulting from the above described reflection phenomena can be eliminated by arranging optical isolators 11 upstream and downstream of the amplifying fiber; in particular, an optical isolator 11a is located upstream of the coupler 7, immediately after the line fiber 3 and an optical isolator 11b is located downstream of the fiber 10 before the next length of line fiber 3.

The optical isolators are devices adapted to allow the unidirectional passage of light; for the purposes of the present invention the optical isolators are required to be of the type independent of the transmission signal polarisation, to have an isolation degree at least higher than 20 dB and to exhibit a low reflectivity, at least lower by 10 dB than the reflectivity value given by the Rayleigh scattering in a fiber of an infinite length and preferably lower by at least 15 dB than the above value.

In fact it has been found that the presence of isolators having the above characteristics ensures that the active element of the amplifier, that is the doped fiber, can operate under conditions which are far enough from those in which noises resulting from reflections of various nature as above described may occur in the presence of amplification gains usually achievable with fiber amplifiers which are of about 30 dB, which value substantially corresponds to the absolute value of the reflectivity given by the Rayleigh scattering in a fiber of infinite length.

In order to achieve higher gains a correspondingly low reflectivity value is required, which reflectivity in accordance with the invention must at all events have an absolute value higher by at least 10 dB, and preferably at least 15 dB, than the expected amplifier value.

The foregoing means that for instance, in order to achieve a gain of 40 dB the reflectivity towards the active fiber in each fiber connected to the active fiber itself is required to be at least lower than -50 dB and preferably lower than -55 dB for the transmission wavelength.

The prescribed reflectivity characteristics of the isolators can be achieved by known means, such as multilayer coatings, surfaces passed through by the transmission signal oblique to the propagation direction of the signal itself and the like; this means is generally well known in the art and therefore it will not be further described.

In addition, in order to avoid noises given by reflections, in accordance with the present invention, the fiber 12 as well, which transmits the luminous pumping power to the coupler 7 and therefore to the active fiber 10, must have a limited reflectivity towards the active fiber itself; in fact a luminous power fraction at the transmission wavelength which propagates back to the coupler 7 is sent within the fiber 12, since couplers commonly used for the purpose in the two coupled branches have a not absolute separation between the two wavelengths for which the coupler themselves are intended; due to this not absolute separation, a not negligible percentage of luminous power at the transmission wavelength, in the range of some percent for example, is coupled on the coupler branch carrying the pumping power.

If this light fraction at the transmission wavelength, at the end of the fiber 12 where it is optically connected to the pumping laser 9, finds a reflection, it will be sent again, through the coupler 7, to the inside of the active fiber and it will contribute as well for the above described phenomena generating interferometric noise.

Therefore for the fiber 12, a reflectivity value lower by 10 dB, and preferably by 15 dB, than the value corresponding to the Rayleigh scattering in an infinite fiber less twice the attenuation value given by the passage of the transmission wavelength in the couplers pumping branch is required.

In other words, it is requested that, at the end of the active fiber 10 connected to the fiber 8, the reflectivity on any fiber converging thereto be globally lower by at least 10 dB, and preferably by 15 dB, than that corresponding to the Rayleigh scattering in an infinite fiber (or correspondingly the absolute value of which is higher than the expected gain); likewise, the reflectivity at the opposite end of the fiber 10 must be restricted.

The prescribed reflectivity characteristics of fiber 12 can be achieved by expedients known in the art, such as multilayer coatings or oblique surfaces; in particular the oblique cut of the end surface 13 of fiber 12 coupled to laser 9 at an angle preferably in the range of 5° to 10° ensures a reflectivity lower than -15 dB which, added to the attenuations due to the passage through the coupler 7 of about -20 dB for each passage for example, gives an overall reflectivity seen from the end of fiber 10 of -55 dB, lower by about 15 dB than the reflectivity given by the Rayleigh scattering (about -30 dB).

The reflection phenomena in fiber 12 could also be eliminated by disposing the optical isolator 11a downstream of the coupler 7, immediately before the active fiber, as shown in Fig. 3; this solution, which allows the use of antireflection expedients to be used at the end of fiber 12, can be adopted in the case in which the loss of pumping power which takes place while the isolator is being crossed is not detrimental to the good operation of the amplifier.

In the case of power amplifiers directly connected downstream of the transmission laser 4 which are fed with an input signal having a high level, higher than the so-called "saturation" level beyond which the power of the transmission signal coming out of the amplifier only depends on the fed pumping power and which emit a high luminous power (higher than 4 dBm for example), in addition to the previously described phenomena, the noise effect given by the reflection due to the Brillouin scattering can occur, in which the luminous power admitted into the optical line fiber coming out of the amplifier excites vibrations in the fiber atoms, which vibrations in turn give rise to the generation of a reflected signal of a wavelength slightly shorter than the direct signal.

This reflected signal can generate a beating with the direct transmission signal, so as to give origin to a noise damaging the transmission quality, being added to the previously described phenomena.

In a telecommunication line, as diagrammatically shown in Fig. 1, the signal emission assembly, generally identified by 14 in the figure, foresees the presence of an optical isolator 15 immediately after the laser 4, which optical isolator performs the function of protecting the laser itself against reflections which could produce damages to the structure thereof; according to the invention a power amplifier 5 which is contiguous to the assembly 14, can therefore leave out of consideration the presence of the optical isolator 11a at the input thereof, as shown in Fig. 4, because the function of eliminating the reflections towards the active fiber of the amplifier can be in this case committed to the already existing isolator 15.

The remaining parts of the power amplifier shown in Fig. 4 are similar, as regards the graphic representation, to those described for line amplifiers and therefore they have been allocated the same reference numerals.

By way of example a telecommunication line has been accomplished in accordance with the diagram shown in Fig. 1, by employing as the transmission laser a directly modulated DFB laser of the traditional type having an emission wavelength of 1535 nm; the reception station 2 consisted of a receiver of the pin/HEMT known type, followed by wide band amplifiers not shown.

The line 3 consisted of low attenuation shifted dispersion fibres having zero dispersion close to the transmission wavelength used; the overall line length was 300 km to which an attenuation of 60 dB corresponded.

The line comprised two optical line amplifiers 6 and a power amplifier 5; these amplifiers were active-fiber amplifiers and consisted of an active silicon-based fiber 10, doped with germanium and erbium, pumped with a laser 9 consisting of a miniaturised Nd-YAG laser, doubled in frequency and diode pumped; the line amplifiers had the structure shown in Fig. 2 and the power amplifier the structure shown in Fig. 4.

The line amplifiers had each an overall gain of 20 dB. The power amplifier had a saturation power equal to 9 dBm and an input power of 0 dBm.

The optical isolators 11 were polarisation control isolators, of a type independent of the transmission signal polarisation, having isolation greater than 35 dB and reflectivity lower than -50 dB; isolators of this kind are commercially available and therefore their structure will not be further described.

The end 13 of the fiber 12 connected to the pumping laser had been cut at an angle of 5°.
The transmission achieved by this structure had a received power of -20 dB and a noise corresponding to -40 dBm.

For comparison a transmission has been accomplished using the same test structure as above described, in which commercially available optical isolators 11 have been employed which had reflectivity equal to -30 dB (corresponding to the reflectivity due to the Rayleigh scattering in the fiber and adapted to avoid the arising of oscillation in the presence of a gain up to 30 dB); under these conditions, although no oscillations were present, noise having intensity of -30 dBm has been noticed, sufficient to prevent the correct transmission reception, which noise is deemed to be due to the effect of the interferometric noise resulting from the Rayleigh scattering and Brillouin scattering within the active-fiber amplifiers.

The optical amplifiers 7 are diagrammatically shown in the figures as fused-fiber couplers, the use of which is particularly convenient for the accomplishment of active-fiber amplifiers; however, it is also possible to use other types of optical couplers, for example of the type used in micro-optics; for the couplers as well, in particular when they are not of the fused-fiber type, a reflectivity lower by at least 10 dB than the reflectivity given by the Rayleigh scattering or with an absolute value higher than the amplification gain for which the amplifier is intended, is required.

Many variations and modifications may be introduced without departing from the scope of the inventive idea in its general features.

## Claims

1. An optical fiber telecommunication line, in which an optical transmission signal is brought from one end of the line to the other end without regenerations, along which line at least an optical fiber amplifier (6a, 6b, 6c) is present comprising an active optical fiber length (10) having a doped core in which the doping is carried out by fluorescent substances, characterised in that all fibres connected to the amplifier's active fiber (10) or belonging to each amplifier (6a, 6b, 6c) have reflection limiting means (11a, 11b, 13) the reflectivity of which, seen from the faced end of the active fiber, is lower by at least 10 dB than the reflectivity corresponding to the Rayleigh scattering in the fiber at the transmission wavelength.

2. An optical fiber telecommunication line according to claim 1, characterised in that the reflection limiting means (11a, 11b, 13) cause reflectivities of the fibres converging towards the active fiber (10) which are equal to or lower by 15 dB than the reflectivity corresponding to the Rayleigh scattering in the fiber at the transmission wavelength.

3. An optical fiber telecommunication line according to claim 1, characterised in that all fibres connected to the amplifier's active fiber or belonging to each amplifier (6a, 6b, 6c) are provided with reflection limiting means having a reflectivity, seen from the faced end of the active fiber, the absolute value of which is higher by at least 10 dB and preferably at least 15 dB than the expected amplifier gain.

4. An optical fiber telecommunication line according to claim 1 or 3, characterised in that the reflection limiting means comprises polarisation control optical isolators (11a, 11b) located upstream and downstream of the optical active fiber (10) of the amplifier (6).

5. An optical fiber telecommunication line according to claim 4, characterised in that the optical isolators (11a, 11b) are of a type insensitive to the polarisation of the transmission signal.

6. An optical fiber telecommunication line according to claim 1, characterised in that the fibres connected to the amplifier's active fiber, devoid of optical isolators, have antireflection coatings and/or an oblique cut of the surface(s) (13) passed through by the transmission signal giving rise to a reflectivity at the transmission signal wavelength lower by at least 10 dB and preferably at least 15 dB than the reflectivity corresponding to the Rayleigh scattering in the fiber at the transmission wavelength.

7. An optical fiber telecommunication line according to claim 3, characterised in that the fibres connected to the amplifier's (6) active fiber (10), devoid of optical isolators, have antireflection coatings and/or an oblique cut of the surface(s) (13) passed through by the transmission signal giving rise to a reflectivity at the transmission signal wavelength the absolute value of which is higher by at least 10 dB and preferably at least 15 dB than the expected amplifier gain.

8. An optical amplifier for optical fiber telecommunication lines of the active fiber type comprising an active optical fiber (10) having a doped core in which the doping is carried out by a fluorescent substance, connected at the ends thereof to the optical fibres of a telecommunication line, to which active optical fiber (10) being also connected, through respective coupling means (7), at least an optical fiber (12) connected to a source of an optical pumping signal (9), characterised in that all fibres connected to the active fiber (10) exhibit reflection limiting means causing a reflectivity, seen from the faced end of the active fiber, lower by at least 10 dB than the reflectivity corresponding to the Rayleigh scattering in the fiber at the transmission wavelength.

9. An optical amplifier according to claim 8, characterised in that the reflection limiting means cause reflectivities of the fibres converging towards the active fiber (10) which are lower by at least 15 dB than the reflectivity due to the Rayleigh scattering in the fiber.

10. An optical amplifier according to claim 8, characterised in that all fibres connected to the active fiber (10) have reflection limiting means exhibiting a reflectivity, seen from the faced end of the active fiber, the absolute value of which is higher by at least 10 dB and preferably by at least 15 dB than the expected amplifier gain.

11. An optical amplifier according to claim 8, characterised in that the reflection limiting means comprises polarisation control optical isolators (11a, 11b) located upstream and downstream of the active optical fiber (10).

12. An optical amplifier according to claim 8, characterised in that the optical isolators (11a, 11b) are of the type insensitive to the transmission signal polarisation.

13. An optical amplifier according to claim 11, characterised in that each optical isolator (11a, 11b) has a reflectivity towards the active fiber at the wavelength of the transmission signal lower by 10 dB and preferably 15 dB than the reflectivity given by the Rayleigh scattering in the line fiber.

14. An optical amplifier according to claim 11, characterised in that each optical isolator (11a, 11b) has a reflectivity towards the active fiber (10) at the wavelength of the transmission signal the absolute value of which is higher by at least 10 dB and preferably at least 15 dB than the expected amplifier gain.

15. An optical amplifier according to claim 8, characterised in that the fiber (12) connected to the optical pumping source (9) is devoid of optical isolators and at the end (13) thereof connected to said source (9) is provided with reflection limiting means comprising antireflection coating layers and/or an oblique cut of the surface(s) passed through by the transmission signal, said reflection limiting means supplying a reflectivity which is lower by 10 dB and preferably by 15 dB than the reflectivity resulting from the Rayleigh scattering, the attenuations due to the passage of the transmission signal and reflected signal through the coupling means being included.

16. An optical amplifier according to claim 15, characterised in that the fiber (12) connected to the optical pumping source (9) is devoid of optical isolators and at the end thereof connected to said source is provided with reflection limiting means comprising antireflection coating layers and/or an oblique cut of the surface(s) passed through by the transmission signal, said reflection limiting means supplying a reflectivity the absolute value of which is higher by at least 10 dB and preferably at least 15 dB than the expected amplifier gain, the attenuations due to the passage of the transmission signal and reflected signal through the coupling means being included.

17. An optical amplifier according to claim 15, characterised in that the end (13) of the optical fiber (12) connected to the pumping signal source (9) is cut at an angle ranging between 5° and 10° with respect to the plane normal to the fiber axis.

18. An optical amplifier according to claim 15, characterised in that the fiber (12) connected to the source (9) of the optical pumping signal is connected to the active fiber (10) through a dichroic coupler (7) and the optical isolators (11a, 11b) are interposed between the active fiber (10) and the optical line fiber (3), at one end thereof, and between the line fiber (3) and the optical coupler (7) immediately contiguous to the active fiber (10), at the other end of the active fiber itself.

19. An optical amplifier according to claim 15, characterised in that the fiber (12) the fiber connected to the source (9) of the optical pumping signal is connected to the active fiber (10) through a dichroic coupler (7) and an optical isolator (11a) is interposed between the active fiber (10) and the dichroic coupler (7).

20. An optical amplifier according to claim 8, characterised in that in case of power amplifiers (5) operating with a power transmission signal higher than the saturation power of the amplifier and connected at a position contiguous to the the transmission signal emitting laser (4), equipped with a respective protection optical isolator (15), an optical isolator (11b) is present only at the downstream end of the active fiber (10) in the running direction of the transmission signal.

Fig. 1

Fig. 2

Fig. 3

Fig. 4

European
Patent Office

EUROPEAN SEARCH
REPORT

Application Number

EP 91 10 8162

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | IEEE PHOTONICS TECHNOLOGY LETTERS, vol. 1, no. 10, October 1989, pages 334-336, IEEE, New York, US; M.Z. IQBAL et al.: "An 11 Gbit/s, 151 KM transmission experiment employing a 1480 nm pumped erbium-doped in-line fiber amplifier" * Figure 1; page 334, right-hand column, paragraph 2 - page 335, left-hand column, end of paragraph 2 * | 1-4,8-11, 13 | H 04 B 10/16 |
| A | PROCEEDINGS OF THE 15TH EUROPEAN CONFERENCE ON OPTICAL COMMUNICATION ECOC '89, Gothenburg, 10th - 14th September 1989, Post deadline papers, vol. 3, pages 42-45; A. RIGHETTI et al.: "An 11 Gbit/s, 260 KM transmission experiment using a directly-modulated 1536 nm DFB laser with two Er-doped fiber amplifiers and clock recovery" * Page 42, paragraph 3 - page 43, end of paragraph 1 * | 1-5,8-14, 20 | |
| A,D | PATENT ABSTRACTS OF JAPAN, vol. 13, no. 8 (E-702)[3356], 10th January 1989, page 72 E 762; & JP-A-63 219 186 (NIPPON TELEGR. & TELEPH. CORP.) 12-09-1988 * Abstract * | 1,4,8,11 | |
| A | GB-A-2 220 789 (STC) * Figures 1,2; abstract; claims 1,2,4,6 * | 1,3,4,8, 10,11, 15-17,19 | TECHNICAL FIELDS SEARCHED (Int. Cl.5) H 04 B H 01 S |

The present search report has been drawn up for all claims

| Place of search | Date of completion of search | Examiner |
|---|---|---|
| The Hague | 06 August 91 | GOUDELIS M. |